# EUROPEAN PATENT APPLICATION

(11) **EP 4 084 144 A1**
(43) Date of publication of application: **02.11.2022**
(21) Application number: 19957362.7
(22) Date of filing: 26.12.2019
(51) Int. Cl.: H01M 4/525, C01G 53/00, H01M 10/052

(54) **POSITIVE ELECTRODE ACTIVE MATERIAL, METHOD FOR PREPARING SAME, AND LITHIUM SECONDARY BATTERY COMPRISING POSITIVE ELECTRODE COMPRISING SAME**

(30) Priority: 24.12.2019 KR 20190174280
(71) Applicant: SM Lab Co., Ltd., Ulsan 44953 (KR)
(72) Inventor: SEO, Min Ho, Hanam-si, Gyeonggi-do 12946 (KR); KIM, Ji Young, Ulju-gun, Ulsan 44920 (KR)
(74) Representative: Loyer & Abello
(86) International application number: PCT/KR2019/018510
(87) International publication number: WO 2021/132763

(57) **Abstract**

The present disclosure relates to a positive electrode active material, a method of preparing the same, and a lithium secondary battery having a positive electrode including the same. The positive electrode active material includes: a lithium transition metal oxide particle in which a portion of Li is substituted with Na, and which includes Ni and Co atoms, wherein the lithium transition metal oxide particle includes a concentration gradient region in which the concentration of Co atoms decreases from the surface toward the center of the particle.

## Description

### TECHNICAL FIELD

The present disclosure relates to a positive electrode active material of a novel composition, a method of preparing the positive electrode active material, and a lithium secondary battery including a positive electrode including the positive electrode active material.

The present disclosure was made with the financial support of the Ministry of Trade, Industry, and Energy (MOTIE) for project identification No. P0009541 titled "Development of High strength, Long lifespan, and Highly Stable Ni-rich NCA (> 210mAh/g, @4.3V) positive electrode Material for Medium-to-large Lithium Secondary Battery".

### BACKGROUND ART

Since lithium secondary batteries were commercialized by Sony in 1991, demand for lithium secondary batteries has increased rapidly in various fields from small home appliances such as mobile information technology (IT) products to medium-to-large electric vehicles and energy storage systems. In particular, for medium-to-large electric vehicles and energy storage systems, a low-cost and high-energy positive electrode material is essential, but cobalt, which is a main raw material of monocrystalline LiCoO2 (LCO), which is a commercially available positive electrode active material, is expensive.

Thus, in recent years, Ni-based positive electrode active materials represented by LiNixCoyMnzO2 (NCM, where x+y+z=1) and LiNixCoyAlzO2 (NCA, where x+y+z=1), in which a portion of Co is substituted with another transition metal, are used instead of LCO as a positive electrode active material for a medium-to-large secondary battery, and these NCM- and NCA-based positive electrode active materials have an advantage in providing low costs and high reversible capacity since nickel is a raw material thereof. Particularly, in terms of high capacity, NCM and NCA having about 50 mol% or more of a molar ratio of Ni have attracted attention. In general, the Ni-based positive electrode active material is prepared by mixing a transition metal compound precursor, which is synthesized by a co-precipitation method, with a lithium source, and then synthesizing the resultant into a solid phase. However, thus-synthesized Ni-based positive electrode materials exist in the form of secondary particles in which small primary particles are agglomerated, and there is a problem in that microcracks are generated in the secondary particles during a long-term charge/discharge process. Microcracks cause side reactions between a new interface of the positive electrode active material and an electrolyte, which results in the deterioration of battery performance, such as the deterioration of stability due to gas generation and the deterioration of battery performance due to exhaustion of the electrolyte. In addition, the electrode density (>3.3 g/cc) needs to be increased to realize high energy density, which causes the collapse of secondary particles, and the electrolyte is depleted due to side reactions with the electrolyte, causing a rapid decrease in initial lifespan. Ultimately, this means that a secondary-particle Ni-based positive electrode active material synthesized by a conventional coprecipitation method cannot achieve high energy density.

In order to solve the above-described problems of secondary-particle Ni-based positive electrode active materials, studies on a single-particle Ni-based positive electrode active material have recently been conducted. A monocrystalline Ni-based positive electrode active material may provide excellent electrochemical performance since no particle collapse occurs when the electrode density is increased (> 3.3 g/cc) to realize high energy density. However, there has been a problem of deterioration of battery stability due to structural and/or thermal instability caused by unstable Ni³⁺ and Ni⁴⁺ ions in the electrochemical evaluation. Therefore, in order to develop a high-energy lithium secondary battery, a technique for stabilizing unstable Ni ions in a monocrystalline Ni-based positive electrode active material is still needed.

### DESCRIPTION OF EMBODIMENTS

### TECHNICAL PROBLEM

Provided is a positive electrode active material with high-energy density and improved long-life characteristics by stabilizing unstable Ni ions in a monocrystal Ni-based positive electrode active material as described above and by suppressing the cracks of the particle during charging and discharging as the structural stability of the positive electrode active material is improved by having a Co concentration gradient region in the positive electrode active material.

### SOLUTION TO PROBLEM

According to an aspect of the present disclosure, a positive electrode active material includes: a lithium transition metal oxide particle in which a portion of Li is substituted with Na, and which includes Ni and Co atoms,
wherein the lithium transition metal oxide particle includes a concentration gradient region in which a concentration of Co atoms decreases from a surface toward a center of the particle.

According to another aspect of the present disclosure, a method of preparing a positive electrode active material includes: preparing a lithium transition metal oxide particle in which a portion of Li is substituted with Na, and which includes Ni and Co atoms;
obtaining a positive electrode active material precursor by mixing the lithium transition metal oxide particle and a Co-containing compound; and
Heat-treating the positive electrode active material precursor to obtain a positive electrode active material,
wherein the positive electrode active material includes a concentration gradient region in which a concentration of Co atoms decreases from the surface toward the center of the positive electrode active material.

According to another aspect of the present disclosure, a lithium secondary battery includes a positive electrode including the positive electrode active material; a negative electrode; and an electrolyte.

### ADVANTAGEOUS EFFECTS OF DISCLOSURE

A positive electrode active material according to an aspect of the present disclosure includes a lithium transition metal oxide particle of a single crystal and a single particle, wherein a portion of Li element in the single crystal is substituted with Na, and as the lithium transition metal oxide particle includes a concentration gradient region in which a concentration of Co among transition metals decreases from a surface toward a center of the lithium transition metal oxide particle, collapse of the particle caused by cracks of the particle during charging and discharging may be prevented, and unstable Ni ions existing in the high-Ni-based lithium transition metal oxide may be stabilized, which increases a capacity per volume and improves lifespan stability.

### BRIEF DESCRIPTION OF DRAWINGS

FIG. 1 shows scanning electron microscope (SEM) images of positive electrode active materials prepared in Example 1 and Comparative Example 1;
FIG. 2 is a graph that shows particle distribution of the positive electrode active materials of Example 1 and Comparative Example 1;
FIG. 3 is a high resolution transmission electron microscopy (HR-TEM) image of the positive electrode active material of Comparative Example 1;
FIG. 4 is an HR-TEM image of the positive electrode active material of Example 1;
FIG. 5 is a lifespan retention rate graph of half-cells prepared in Example 4 and Comparative Examples 8 to 12;
FIG. 6 is a lifespan retention rate graph of half-cells prepared in Example 5 and Comparative Example 13;
FIG. 7 is a lifespan retention rate graph of half-cells prepared in Example 6 and Comparative Example 14; and
FIG. 8 is a schematic view of a lithium battery according to an example embodiment.

### MODE OF DISCLOSURE

Hereinafter, as the present inventive concept allows for various changes and numerous embodiments, particular embodiments will be illustrated in the drawings and described in detail in the written description. However, this is not intended to limit the present inventive concept to particular modes of practice, and it is to be appreciated that all changes, equivalents, and substitutes that do not depart from the spirit and technical scope are encompassed in the present inventive concept.

The terms used herein are merely used to describe particular embodiments, and are not intended to limit the present inventive concept. An expression used in the singular encompasses the expression of the plural, unless it has a clearly different meaning in the context. As used herein, it is to be understood that the terms such as "including," "having," and "comprising" are intended to indicate the existence of the features, numbers, steps, actions, components, parts, ingredients, materials, or combinations thereof disclosed in the specification, and are not intended to preclude the possibility that one or more other features, numbers, steps, actions, components, parts, ingredients, materials, or combinations thereof may exist or may be added. The symbol "/" used herein may be interpreted as "and" or "or" according to the context.

In the drawings, the thicknesses of layers and regions are exaggerated or reduced for clarity. Like reference numerals in the drawings denote like elements. Throughout the specification, it will be understood that when a component, such as a layer, a film, a region, or a plate, is referred to as being "on" another component, the component may be directly on the other component or intervening components may be present thereon. Throughout the specification, while such terms as "first," "second," etc., may be used to describe various components, such components must not be limited to the above terms. The above terms are used only to distinguish one component from another.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"Group" refers to a group of the periodic table of the elements according to the International Union of Pure and Applied Chemistry ("IUPAC") Groups 1-18 group classification system.

While a particular embodiment has been described, alternatives, modifications, variations, improvements, and substantial equivalents that are or may be presently unforeseen may arise to applicants or others skilled in the art. Accordingly, the appended claims as filed and as they may be amended are intended to embrace all such alternatives, modifications variations, improvements, and substantial equivalents.

Hereinafter, a positive electrode active material, a method of preparing the same, and a lithium secondary battery including a positive electrode including the positive electrode active material according to example embodiments will be described in detail.

A positive electrode active material according to an embodiment includes a lithium transition metal oxide particle in which a portion of Li is substituted with Na, and which includes Ni and Co atoms, wherein the lithium transition metal oxide particle includes a concentration gradient region in which a concentration of Co atoms decreases from the surface toward the center of the particle.

As a portion of Li is substituted with Na, structural modification according to desorption of Li ions during charging is suppressed, which improves long lifespan characteristics of the positive electrode active material, and as the lithium transition metal oxide particle includes a concentration gradient region in which a concentration of Co atoms decreased from the surface toward the center of the particle, the stability of the crystal structure is further improved, which suppresses collapse of the crystal during a charging and discharging process, and thus not only the lifespan characteristics are improved, but also distribution of unstable Ni(lll) and Ni(IV) ions on the surfaces is reduced, and increases distribution of Ni(ll) in the core, which not only suppresses a side reaction between Ni ions and an electrolyte solution, but also resulting a high content of Ni ions to obtain a high capacity of the positive electrode active material. Therefore, the positive electrode active material has high-capacity and long lifespan characteristics. Also, as will be described later, when unstable Ni(lll) and Ni(IV) are reduced due to additional doping of transition metals such as W, Mg, and Ti, structural stability is further improved, and thus lifespan characteristics are significantly improved.

According to an embodiment, the concentration gradient region may include a region up to 500 nm from the surface toward the center of the lithium transition metal oxide particle.

For example, the concentration gradient region may include a region up to 250 nm from the surface toward the center of the lithium transition metal oxide particle.

When the concentration gradient region exists in these distances from the surface of the lithium transition metal oxide particle, high-capacity and long lifespan characteristics of the positive electrode active material may be achieved.

According to an embodiment, in the concentration gradient region, a concentration of Ni atoms may increase from the surface toward the center of the lithium transition metal oxide particle.

According to an embodiment, in the concentration gradient region, a concentration of Co atoms may decrease, and a concentration of Ni atoms may increase from the surface toward the center of the lithium transition metal oxide particle.

Due to the gradual decrease of the Co atom concentration and the gradual increase of the Ni atom concentration from the surface of the lithium transition metal oxide particle, high-capacity and long lifespan characteristics of the positive electrode active material may be achieved.

According to an embodiment, the lithium transition metal oxide particle may include a lithium transition metal oxide represented by Formula 1:

Formula 1 Li₁₋ₓNaₓM_{1-(α+β+γ)}W_{α}Mg_{β}Ti_{γ}O₂₋ₐSₐ

In Formula 1, M, x, α, β, γ, and a will be described in detail later in the specification.

In the lithium transition metal oxide represented by Formula 1, when a portion of Li is substituted with Na, a portion of M is substituted with W, Mg, and Ti, and a portion of O is substituted with S, structural stability of the lithium transition metal oxide during charging and discharging of a lithium secondary battery including the lithium transition metal oxide may improve, which may increase a capacity per unit volume and improve lifespan stability.

Also, regarding a high-Ni-based lithium transition metal oxide in which M includes Ni, substitution of small amounts of W, Mg, and Ti generates reduction of unstable nickel ions, e.g., Ni³⁺ and Ni⁴⁺ existing in the lithium transition metal oxide into Ni²⁺ which is a stable form of nickel ions, and thus deterioration of the positive electrode active material caused by the side reaction between the unstable nickel ions and an electrolyte solution during charging and discharging and a decrease in capacity may be suppressed.

Also, regarding a high-Ni-based lithium transition metal oxide in which M includes Ni, substitution of small amounts of W, Mg, and Ti generates reduction of unstable nickel ions, e.g., Ni³⁺ and Ni⁴⁺ existing in the lithium transition metal oxide into Ni²⁺ which is a stable form of nickel ions, and thus deterioration of the positive electrode active material caused by the side reaction between the unstable nickel ions and an electrolyte solution during charging and discharging and a decrease in capacity may be suppressed.

According to an embodiment, in Formula 1, M may be at least one element selected from alkali metal elements, alkaline earth metal elements, transition metal elements, post-transition metal elements, and non-metal elements, other than W, Mg, Ti, Na, and S.

For example, M may be at least one element selected from K, Rb, Cs, Fr, Be, Ca, Sr, Ba, Ra, Sc, Y, La, Zr, Hf, V, Nb, Ta, Cr, Mo, Mn, Tc, Re, Fe, Ru, Os, Co, Rh, Ir, Ni, Pd, Pt, Cu, Ag, Au, Zn, Cd, Hg, B, Al, Ga, In, TI, C, Si, Ge, Sn, Pb, N, P, As, Sb, Bi, N, P, As, Sb, Bi, Se, Te, and Po.

According to an embodiment, M may be at least one element selected from alkali metal elements, alkaline earth metal elements, transition metal elements, post-transition metal elements, and non-metal elements, other than W, Mg, Ti, Na, and S.

For example, M may be at least one element selected from Be, Ca, Sr, Ba, Ra, Sc, Y, La, Zr, Hf, V, Nb, Ta, Cr, Mo, Mn, Tc, Re, Fe, Ru, Os, Co, Rh, Ir, Ni, Pd, Pt, Cu, Ag, Au, Zn, Cd, Hg, B, Al, Ga, In, TI, C, Si, Ge, Sn, Pb, N, P, As, Sb, Bi, N, P, As, Sb, Bi, Se, Te, and Po.

According to an embodiment, M may be at least one element selected from Ni, Co, Mn, Al, V, Ca, Zr, B, and P.

For example, M may be at least one element selected from Ni, Co, Mn, Al, V, Ca, Zr, B, and P. For example, M may be at least one element selected from Co, Mn, and Al.

According to an embodiment, x may satisfy 0<x≤0.01. Here, x refers to a substitution molar ratio of Na to Li in the lithium transition metal oxide represented by Formula 1. As a portion of Li of the lithium transition metal oxide represented by Formula 1 is substituted with Na, the structural stability may be improved. When Na is substituted in a lattice site where Li is located, the expansion of a crystal structure due to a repulsive force between oxygen atoms in the lithium transition metal oxide is suppressed when lithium is desorbed in a charged state by the intervention of Na, which has an ionic radius larger than that of lithium, and as a result, the structural stability of the lithium transition metal oxide is achieved even during repeated charging.

According to an embodiment, α may satisfy 0<α≤0.01. Here, α refers to a substitution molar ratio of W to M element in the lithium transition metal oxide represented by Formula 1. Here, α refers to a substitution molar ratio of W to M element in the lithium transition metal oxide represented by Formula 1. When the substitution molar ratio of W is more than 0.01, structural stability may be deteriorated due to distortion of the crystal structure, and WO₃ may be formed as an impurity, thereby causing deterioration of electrochemical characteristics.

According to an embodiment, β may satisfy 0< β ≤0.005. Here, β refers to a substitution molar ratio of Mg to M element in the lithium transition metal oxide represented by Formula 1. When the substitution molar ratio of Mg satisfies the above range, structural expansion of the lithium transition metal oxide in a charged state may be suppressed.

According to an embodiment, γ may satisfy 0< γ ≤0.005. Here, γ refers to a substitution molar ratio of Ti to M element in the lithium transition metal oxide represented by Formula 1. When the substitution molar ratio of Ti satisfies the above range, structural expansion of the lithium transition metal oxide in a charged state may be suppressed.

When the lithium transition metal oxide is substituted with W, Mg, and Ti in the above molar ratios, even when lithium is desorbed in the charged state, the structural expansion of crystal due to the interaction between oxygen atoms in the lithium transition metal oxide is suppressed, thereby improving structural stability to improve lifespan characteristics.

According to an embodiment, α, β, and γ may satisfy 0<α+β+γ≤0.02. For example, α, β, and γ may satisfy 0<α+β+γ≤0.016. When α+β+γ satisfies the above range, the structural stability of the lithium transition metal oxide is guaranteed. When α+β+γ is more than 0.02, an impurity phase is formed, which not only may act as a resistance during lithium desorption, but also may cause collapse of the crystal structure during repeated charging.

According to an embodiment, in Formula 1, β and γ may satisfy 0<β≤0.003 and 0<γ≤0.003, respectively.

For example, in Formula 1, β=γ may be satisfied. In the case of β=γ (for example, when molar ratios of Mg and Ti are equal to each other), charge is balanced in the lithium transition metal oxide during charging and discharging to suppress the collapse of the crystal structure, thereby improving structural stability, and as a result, improving lifespan characteristics.

According to an embodiment, a may satisfy 0<a≤0.01. For example, a may satisfy 0<a≤0.005, 0<a≤0.003, or 0<a≤0.001. Here, a refers to a substitution molar ratio of S to O element in the lithium transition metal oxide represented by Formula 1.

As a portion of oxygen element is substituted with S, the bonding force with the transition metal increases, and thus the transition of the crystal structure in the lithium transition metal oxide is suppressed, and as a result, the structural stability in the lithium transition metal oxide is improved.

Meanwhile, when the substitution molar ratio of S is more than 0.01, the crystal structure of the lithium transition metal oxide becomes unstable due to the repulsive force of S anions, and rather the lifespan characteristics thereof deteriorate.

According to an embodiment, the lithium transition metal oxide may be a single particle. A single particle is a concept that is differentiated from a secondary particle formed by agglomeration of a plurality of particles or a particle formed by agglomeration of a plurality of particles and coating the periphery of the agglomerate. Since the lithium transition metal oxide has a single particle shape, it is possible to prevent the particle from being broken even at a high electrode density. Accordingly, it is possible to realize a high energy density of a positive electrode active material including a lithium transition metal oxide. In addition, as compared with the secondary particle in which a plurality of single particles are agglomerated, it is possible to realize high energy density by suppressing breakage during a pressing process, and it is also possible to prevent lifespan deterioration due to breakage of the particle.

According to an embodiment, the lithium transition metal oxide may have a single crystal. A single crystal has a concept that is distinct from a single particle. The single particle refers to a particle formed of one particle regardless of the type and number of crystals therein, and the single crystal refer to having only one crystal in a particle. The single crystal lithium transition metal oxide has not only very high structural stability, but also has better lithium ion conduction than polycrystals, and thus has excellent highspeed charging characteristics compared to a polycrystalline active material.

According to an embodiment, the positive electrode active material is formed as a single crystal and a single particle. Since the positive electrode active material is formed as a single crystal and a single particle, a structurally stable and high-density electrode may be implemented, and a lithium secondary battery including the same may have both improved lifespan characteristics and high energy density.

According to an embodiment, the lithium transition metal oxide may be represented by any one of Formulae 2 to 4:

Formula 2 Li_{1-x'}Na_{x'}Ni_{y1'}Co_{y2'}Mn_{y3'}W_{α'}Mg_{β'}Ti_{γ'}O_{2-a'}S_{a'}

Formula 3 Li_{1-xʺ}Na_{xʺ}Ni_{y1"}CO_{y2"}Al_{y3"}W_{α"}Mg_{βʺ}Ti_{γ"}O_{2-a"}S_{a"}

Formula 4 Li_{1-x‴}Na_{x‴}Ni_{y1‴}CO_{y2‴}W_{α‴}Mg_{β‴}Ti_{γ‴}O_{2-a‴}S_{a‴}

According to an embodiment, in Formula 2,
0<x'≤0.01, 0<α'≤0.01, 0<β'≤0.005, 0<γ'≤0.005, 0<a'≤0.01, 0<α'+β'+γ'≤0.02, 0.48≤y1'<1, 0<y2' ≤0.2, 0<y3'≤0.3, and y1'+y2'+y3'+ α'+ β'+ γ'=1.

In Formula 3,
0<x"≤0.01, 0<α"≤0.01, 0<β"≤0.005, 0<γ"≤0.005, 0<a"≤0.01, 0<α"+β"+γ"≤0.02, 0.73≤y1"<1, 0<y2" ≤0.2, 0<y3"≤0.05, and y1 "+y2"+y3"+ α"+ β"+ y"=1.

In Formula 4,
0<x'"≤0.01, 0<α"'≤0.01, 0<β"'≤0.005, 0<γ‴≤0.005, 0<a‴≤0.01, 0<α‴+β‴+γ‴≤0.02, 0.78≤y1"'<1, 0<y2'" ≤0.2, and y1"'+y2"'+ α‴+ β‴+ γ‴=1.

For example, in Formula 2, 0<β'≤0.003, 0<y'≤0.003, and 0<α'+β'+γ'≤0.016; in Formula 3, 0<β"≤0.003, 0<γ"≤0.003, and 0<α"+β"+γ"≤0.016; in Formula 4, 0<β‴≤0.003, 0<γ‴≤0.003, and 0<α‴+β‴+γ‴≤0.016.

Since the lithium transition metal oxide satisfies the composition, unstable Ni ions existing in the lithium transition metal oxide may be stabilized, and high energy density and long lifespan stability may be maintained.

Generally, in a positive electrode active material including a high-nickel-based lithium nickel cobalt manganese oxide, stabilization of unstable Ni ions is essential. However, when the lithium transition metal oxide is used, since W, Mg, and Ti are introduced into some of transition metal sites in the crystal, the positive electrode active material may achieve an overall charge balance, thereby inhibiting the oxidation from Ni(II) ions to unstable Ni(lll) or Ni(IV) ions and reducing unstable NI(III) or Ni(IV) to Ni(II). Meanwhile, the loss of conductivity due to substitution of some of the transition metals with heterogeneous elements W, Mg, and Ti was compensated for by substitution of a portion of O with S, and a decrease in conductivity of Li due to structural deformation during charge and discharge was also suppressed by substituting a portion of Li with Na, thereby obtaining a high-capacity and long-lifespan positive electrode active material having a structurally stable single crystal.

According to an embodiment, the average particle diameter (D₅₀) of the lithium transition metal oxide may be about 0.1 µm to about 20 µm. For example, the average particle diameter (D₅₀) of the lithium transition metal oxide may be about 0.1 µm to about 15 µm, about 0.1 µm to about 10 µm, about 1 µm to about 20 µm, about 5 µm to about 20 µm, about 1 µm to about 15 µm, about 1 µm to about 10 µm, about 5 µm to about 15 µm, or about 5 µm to about 10 µm. When the average particle diameter of the lithium transition metal oxide is within the above range, a desired energy density per volume may be realized. When the average particle diameter of the lithium transition metal oxide is more than about 20 µm, a sharp drop in charging and discharging capacity occurs, and when it is less than about 0.1 µm, it is difficult to obtain a desired energy density per volume.

Hereinafter, a method of preparing a positive electrode active material according to an aspect will be described in detail.

The method of preparing a positive electrode active material according to an aspect includes: preparing a lithium transition metal oxide particle in which a portion of Li is substituted with Na, and which includes Ni and Co atoms; obtaining a positive electrode active material precursor by mixing the lithium transition metal oxide particle and a Co-containing compound; and heat-treating the positive electrode active material precursor to obtain a positive electrode active material, wherein the positive electrode active material includes a concentration gradient region in which a concentration of Co atoms decreases from the surface toward the center of the particle.

According to an embodiment, the preparing of the lithium transition metal oxide particle may include
mixing a Li-containing compound, a Na-containing compound, a W-containing compound, a Mg-containing compound, a Ti-containing compound, a M-containing compound, and a S-containing compound to prepare a lithium transition metal oxide precursor; and heat-treating the lithium transition metal oxide precursor to prepare a positive electrode active material comprising a lithium transition metal oxide represented by Formula 1:

   Formula 1 Li₁₋ₓNaₓM_{1-(α+β+γ)}W_{α}Mg_{β}Ti_{γ}O₂₋ₐSₐ

   wherein, in Formula 1,
M is at least one element selected from alkali metal elements, alkaline earth metal elements, transition metal elements, post-transition metal elements, and non-metal elements, other than W, Mg, Ti, Na, and S, and
0<x≤0.01, O<α≤0.01, 0<β≤0.005, 0<γ≤0.005, 0<a≤0.01, and O<α+β+γ≤0.02.

Detailed description of Formula 1 is the same as described above.

The mixing may include mechanical mixing of the specific element-containing compounds. The mechanical mixing of the compounds is performed by a drying method. The mechanical mixing is to form a uniform mixture by pulverizing and mixing materials to be mixed by applying a mechanical force. The mechanical mixing may be performed using a mixing device for example, a ball mill using chemically inert beads, a planetary mill, a stirred ball mill, or a vibrating mill. To attain improved mixing effects, a small amount of alcohol such as ethanol, or a higher fatty acid such as stearic acid may be optionally added.

The mechanical mixing may be performed in an oxidizing atmosphere. This is to prevent reduction of a transition metal in the transition metal source (for example, a Ni compound) to thereby implement structural stability of the active material.

Examples of the Li-containing compound may include a lithium hydroxide, a lithium oxide, a lithium nitride, a lithium carbonate, or a combination thereof, but embodiments are not limited thereto. For example, the Li-containing compound may be LiOH or Li2CO₃.

Examples of the Na-containing compound may be a hydroxide of Na, an oxide of Na, a nitride of Na, a carbonate of Na, or a combination thereof, but embodiments are not limited thereto. For example, the Na-containing compound may be NaOH, Na₂CO₃, or a combination thereof.

Examples of the W-containing compound may include a hydroxide of W, an oxide of W, a nitride of W, a carbonate of W, or a combination thereof, but embodiments are not limited thereto. For example, the W-containing compound may be W(OH)₆, WO₃, or a combination thereof.

Examples of the Mg-containing compound may include a hydroxide of Mg, an oxide of Mg, a nitride of Mg, a carbonate of Mg, or a combination thereof, but embodiments are not limited thereto. For example, the Mg-containing compound may be Mg(OH)₂, MgCO₃, or a combination thereof.

Examples of the Ti-containing compound may include a hydroxide of Ti, an oxide of Ti, a nitride of Ti, a carbonate of Ti, or a combination thereof, but embodiments are not limited thereto. For example, the Ti-containing compound may be Ti(OH)₂, TiO₂, or a combination thereof.

The M-containing compound may include a hydroxide, an oxide, a nitride, a carbonate, or a combination thereof of at least one element selected from alkali metal elements, alkaline earth metal elements, transition metal elements, metalloid elements, and non-metal elements, and a combination thereof, other than W, Mg, Ti, Na, and S, but embodiments are not limited thereto. For example, the M-containing compound may be Ni_{0.8}Co_{0.1}Mn_{0.1}(OH)₂, Ni_{0.9}Co_{0.05}Al_{0.05}(OH)₂, or Ni_{0.9}Co_{0.1}(OH)₂.

The S-containing compound may include a hydroxide of S, an oxide of S, a nitride of S, a carbonate of S, or a combination thereof, but embodiments are not limited thereto. For example, the S-containing compound may be (NH₄)₂S.

According to an embodiment, the obtaining of the positive electrode active material precursor may further include a Co-containing compound as a mixture material.

The Co-containing compound may include a hydroxide of Co, an oxide of Co, a nitride of Co, a carbonate of Co, an acetic acid salt of Co, or a combination thereof, as a compound capable of providing a Co element. For example, the Co-containing compound may be cobalt acetate.

In the process of preparing a lithium transition metal oxide particle, the heat-treating may include a first heat-treating process and a second heat-treating process. The first heat-treating process and the second heat-treating process may be continuously performed or may be performed with a rest period after the first heat-treating process. The first heat-treating process and the second heat-treating process may be performed in the same chamber or in different separate chambers.

A heat-treating temperature of the first heat-treating process may be higher than a heat-treating temperature of the second heat-treating process.

The heat-treating temperature of the first heat-treating process may be in a range of about 800 °C to about 1200 °C. The heat-treating temperature may be in a range of, for example, about 850 °C to about 1200 °C, about 860 °C to about 1200 °C, about 870 °C to about 1200 °C, about 880 °C to about 1200 °C, about 890 °C to about 1200 °C, or about 900 °C to about 1200 °C, but embodiments are not limited thereto, and, for example, the heat-treating temperature of the first heat-treating process may include any range of two values within each of these temperature ranges.

A heat-treating temperature of the second heat-treating process may be in a range of about 700 °C to about 800 °C. The heat-treating temperature may be in a range of, for example, about 710 °C to about 800 °C, about 720 °C to about 800 °C, about 730 °C to about 800 °C, about 740 °C to about 800 °C, about 750 °C to about 800 °C, about 700 °C to about 780 °C, about 700 °C to about 760 °C, about 700 °C to about 750 °C, or about 700 °C to about 730 °C, but embodiments are not limited thereto, and, for example, the heat-treating temperature of the second heat-treating process may include any range of two values within each of these temperature ranges.

According to an embodiment, a heat-treating time of the first heat-treating process may be shorter than a heat-treating time of the second heat-treating process.

For example, the heat-treating time of the first heat-treating process may be in a range of about 3 hours to about 5 hours, about 4 hours to about 5 hours, or about 3 hours to about 4 hours, but embodiments are not limited thereto, and, for example, the heat-treating time of the first heat-treating process may include any range of two values within each of these ranges.

For example, the heat-treating time of the second heat-treating process may be in a range of about 10 hours to about 20 hours or about 10 hours to about 15 hours, but embodiments are not limited thereto, and, for example, the heat-treating time of the second heat-treating process may include any range of two values within each of these ranges.

The first heat-treating process may include a heat-treating process performed at a temperature in a range of about 800 °C to about 1200 °C for about 3 hours to about 5 hours.

The second heat-treating process may include a heat-treating process performed at a temperature in a range of about 700 °C to about 800 °C for about 10 hours to about 20 hours.

In the first heat-treating process, the lithium transition metal oxide may form the positive electrode active material having a layered structure and at the same time induce growth of particles such that a monocrystalline form may be attained. In the first heat-treating process, individual primary particles in the lithium transition metal oxide having a secondary particle shape may rapidly grow, losing the ability to withstand against stress between the particles, such that the insides thereof are exposed and the exposed primary particles are fused together, thereby forming the monocrystalline positive electrode active material for a secondary battery. The second heat-treating process may be performed at a temperature lower than the temperature of first heat-treating process for a longer time, to thereby increase a degree of crystallinity of the layered structure formed in the first heat-treating process. Through the first and second heat-treating processes, a single-phase, monocrystalline, single-particle high-Ni-based positive electrode active material may be obtained.

According to an embodiment, in the obtaining of the positive electrode active material precursor, the Co-containing compound may be included in an organic solvent. For example, the organic solvent may be a volatile solvent. For example, the organic solvent may be a solvent such as methanol or ethanol, which is volatile at a temperature of about 80 °C or lower.

According to an embodiment, the heat-treating may be performed at a temperature in a range of about 500 °C to about 900 °C. For example, the heat-treating may be performed at a temperature in a range of about 600 °C to about 900 °C. According to an embodiment, the heat-treating may be performed for about 1 hour to about 6 hours. For example, the heat-treating may be performed for about 2 hours to about 4 hours.

According to an embodiment, the heat-treating may be performed at a temperature in a range of about 500 °C to about 900 °C for about 1 hour to about 6 hours. When the positive electrode active material precursor is fired at the heat-treating temperature and time, a positive electrode active material including a concentration gradient region in which Co atoms have concentration gradient may be obtained.

According to an embodiment, the concentration gradient region may include a region of about 500 nm or less from the surface toward the center of the lithium transition metal oxide particle. It is deemed that the concentration gradient region of Co element was formed during a process of the Co element penetrating from the surface and diffusing into the lithium transition metal oxide particle in the heat-treating of the positive electrode active material.

According to an embodiment, the lithium transition metal oxide prepared according to the preparation method may be a single crystal and a single particle, where the single crystal may have a layered structure. Also, the lithium transition metal composite oxide may have an average particle diameter of about 0.1 µm to about 20 µm.

Also, in the lithium transition metal oxide prepared according to the method of preparing the positive electrode active material, W, Mg, and Ti elements are substituted at the sites of M element in the structure, S element is substituted at the site of O, Na element is substituted at the site of Li, thereby not only inhibiting the oxidation of Ni²⁺, but also causing the reduction of the existing unstable Ni³⁺ ions to Ni²⁺ ions to obtain a lithium transition metal oxide having structural stability and high density. Also, reduced Ni²⁺ ions and Li⁺ ions have similar ionic radii to each other, so that Li/Ni disordering is promoted, and void lattice is filled with Ni ions during Li desorption, thereby improving the structural stability of the crystal.

Moreover, due to further including the Co concentration gradient region, structural stability was improved, and capacity and lifespan characteristics were improved, as compared to those of conventional cases when merely transition metals are substituted.

According to another aspect, provided is a positive electrode including the positive electrode active material.

According to another aspect, provided is a lithium secondary battery including the positive electrode; a negative electrode; and an electrolyte.

The positive electrode and the lithium secondary battery including the same may be prepared in the following manner.

First, a positive electrode is prepared.

For example, a positive electrode active material composition in which the above-described positive electrode active material, a conducting agent, a binder, and a solvent are mixed is prepared. A positive electrode plate is prepared by directly coating a metal current collector with the positive electrode active material composition. In some embodiments, the positive electrode plate may be prepared by casting the positive electrode active material composition onto a separate support, separating a film from the support and then laminating the separated film on a metal current collector. The positive electrode is not limited to the above-described form, but may have a form other than the above-described form.

Examples of the conducting agent may include graphite such as natural graphite and artificial graphite; carbon black; conductive tubes such as carbon nanotubes; conductive whiskers of fluorocarbon, zinc oxide, and potassium titanate; and conductive metal oxides such as titanium oxide, but embodiments are not limited thereto, and any material that may be used as a conducting agent in the art may be used.

Examples of the binder may include a vinylidene fluoride / hexafluoropropylene copolymer, polyvinylidene fluoride (PVDF), polyacrylonitrile, polymethylmethacrylate, polytetrafluoroethylene, and mixtures thereof; a metal salt; or a styrene butadiene rubber-based polymer, but embodiments are not limited thereto, and any material that may be used as a binder in the art may be used. In some embodiments, examples of the binder may include a lithium salt, a sodium salt, a calcium salt, or a Na salt of these polymers.

Examples of the solvent may include N-methyl pyrrolidone, acetone, or water, but embodiments are not limited thereto, and any material that may be used as a solvent in the art may be used.

The amounts of the positive electrode active material, the conducting agent, the binder, and the solvent may be in ranges that are commonly used in lithium batteries. At least one of the conducting agent, the binder, and the solvent may be omitted according to the use and the structure of the lithium battery.

Next, a negative electrode is prepared.

For example, a negative electrode active material, a conducting agent, a binder, and a solvent are mixed to prepare a negative electrode active material composition. The negative electrode active material composition may be directly coated on a metallic current collector having a thickness of about 3 µm to about 500 µm and dried to prepare a negative electrode plate. In some embodiments, the negative electrode active material composition may be cast on a separate support to form an negative electrode active material film, which may then be separated from the support and laminated on a metallic current collector to prepare a negative electrode plate.

Examples of a material for the negative electrode current collector are not particularly limited as long as they do not cause a chemical change to a battery. For example, the material for the negative electrode current collector may be copper, nickel, and copper that is surface-treated with carbon.

In some embodiments, the negative electrode active material may be any material available as an negative electrode active material for a lithium battery in the art. For example, the negative electrode active material may include at least one selected from the group consisting of lithium metal, a metal alloyable with lithium, a transition metal oxide, a non-transition metal oxide, and a carbonaceous material.

Examples of the metal alloyable with lithium are Si, Sn, Al, Ge, Pb, Bi, Sb, a Si-Y alloy (where Y is an alkali metal, an alkaline earth metal, a Group XIII element, a Group XIV element, a transition metal, a rare earth element, or a combination thereof, and Y is not Si), and a Sn-Y alloy (where Y is an alkali metal, an alkaline earth metal, a Group XIII element, a Group XIV element, a transition metal, a rare earth element, or a combination thereof, and Y is not Sn). In some embodiments, Y may be magnesium (Mg), calcium (Ca), strontium (Sr), barium (Ba), radium (Ra), scandium (Sc), yttrium (Y), titanium (Ti), zirconium (Zr), hafnium (Hf), rutherfordium (Rf), vanadium (V), niobium (Nb), tantalum (Ta), dubnium (Db), chromium (Cr), molybdenum (Mo), tungsten (W), seaborgium (Sg), technetium (Tc), rhenium (Re), bohrium (Bh), iron (Fe), lead (Pb), ruthenium (Ru), osmium (Os), hassium (Hs), rhodium (Rh), iridium (Ir), palladium (Pd), platinum (Pt), copper (Cu), silver (Ag), gold (Au), zinc (Zn), cadmium (Cd), boron (B), aluminum (Al), gallium (Ga), tin (Sn), indium (In), titanium (Ti), germanium (Ge), phosphorus (P), arsenic (As), antimony (Sb), bismuth (Bi), sulfur (S), selenium (Se), or tellurium (Te).

Examples of the transition metal oxide include a lithium titanium oxide, a vanadium oxide, and a lithium vanadium oxide.

Examples of the non-transition metal oxide include SnO₂ and SiOₓ (where 0<x<2).

Examples of the carbonaceous material may be crystalline carbon, amorphous carbon, and mixtures thereof. Examples of the crystalline carbon may include graphite, such as natural graphite or artificial graphite that are in shapeless, plate, flake, spherical, or fibrous form. Examples of the amorphous carbon may be soft carbon (carbon sintered at low temperatures), hard carbon, meso-phase pitch carbides, and sintered cokes.

In some embodiments, the conducting agent, the binder, and the solvent used for the negative electrode active material composition may be the same as those used for the positive electrode active material composition.

The amounts of the negative electrode active material, the conducting agent, the binder, and the solvent may be the same levels generally used in the art for lithium batteries. At least one of the conducting agent, the binder, and the solvent may be omitted according to the use and the structure of the lithium battery.

Next, a separator to be inserted between the positive electrode and the negative electrode is prepared.

The separator for the lithium battery may be any separator that is commonly used in lithium batteries. The separator may have low resistance to migration of ions in an electrolyte and have an excellent electrolyte-retaining ability. The separator may be a single layer or multiple layers. For example, the separator may be formed of glass fibers, polyester, Teflon, polyethylene, polypropylene, polytetrafluoroethylene (PTFE), or a combination thereof, which may have a non-woven form or a woven form. The separator may have a mixed multi-layer structure such as a two-layer separator of polyethylene/polypropylene, a three-layer separator of polyethylene/polypropylene/polyethylene, and a three-layer separator of polypropylene/polyethylene/polypropylene. For example, a rollable separator such as polyethylene or polypropylene may be used for a lithium ion battery, and a separator with a good organic electrolytic solution-retaining ability may be used for a lithium ion polymer battery. For example, the separator may be manufactured in the following manner.

In some embodiments, a polymer resin, a filler, and a solvent may be mixed together to prepare a separator composition. Then, the separator composition may be directly coated on an electrode, and then dried to form the separator. In some embodiments, the separator composition may be cast on a support and then dried to form a separator film, which may then be separated from the support and laminated on an electrode to form the separator.

The polymer resin used to manufacture the separator may be any material that is used as a binder for electrode plates. Examples of the polymer resin may be a vinylidenefluoride/hexafluoropropylene copolymer, polyvinylidene fluoride (PVDF), polyacrylonitrile, polymethylmethacrylate, and a mixture thereof.

Next, an electrolyte is prepared.

For example, the electrolyte may be an organic electrolyte solution. In some embodiments, the electrolyte may be in a solid phase. Examples of the electrolyte may be boron oxide and lithium oxynitride, but embodiments are not limited thereto, and any material available as a solid electrolyte in the art may be used. In some embodiments, the solid electrolyte may be formed on the negative electrode by, for example, sputtering.

For example, the organic electrolyte solution may be prepared by dissolving a lithium salt in an organic solvent.

The organic solvent may be any solvent available as an organic solvent in the art. Examples of the organic solvent may be cyclic carbonates such as propylene carbonate, ethylene carbonate, fluoroethylene carbonate, butylene carbonate, and vinylene carbonate; chain carbonates such as dimethyl carbonate, diethyl carbonate, methylethyl carbonate, methylpropyl carbonate, ethylpropyl carbonate, methylisopropyl carbonate, dipropyl carbonate, and dibutyl carbonate; esters such as methyl acetate, ethyl acetate, propyl acetate, methyl propionate, ethyl propionate, and y-butyrolactone; ethers such as 1,2-dimethoxyethane, 1,2-diethoxyethane, tetrahydrofuran, 1,2-dioxane, and 2-methyltetrahydrofuran; nitriles such as acetonitrile; and amides such as dimethylformamide. These organic solvents may be alone or in combination of two or more. For example, a solvent prepared by mixing a cyclic carbonate and a chain carbonate.

In some embodiments, the electrolyte may be a gel-phase polymer electrolyte prepared by impregnating a polymer electrolyte such as polyethylene oxide or polyacrylonitrile with an electrolyte solution or may be an inorganic solid electrolyte such as Lil, Li₃N, LiₓGe_{y}P_{z}S_{α}, or LiₓGe_{y}P_{z}S_{α}X_{δ} (where X is F, CI, or Br).

In some embodiments, the lithium salt may be any material available as a lithium salt in the art. In some embodiments, the lithium salt may be LiPF₆, LiBF₄, LiSbF₆, LiAsF₆, LiClO₄, LiCF₃SO₃, Li(CF₃SO₂)₂N, LiC₄F₉SO₃, LiAlO₂, LiAlCl₄, LiN(CₓF₂ₓ₊₁SO₂)(C_{y}F_{2y}+₁SO₂) (where x and y are each independently a natural number), LiCI, Lil, or a mixture thereof.

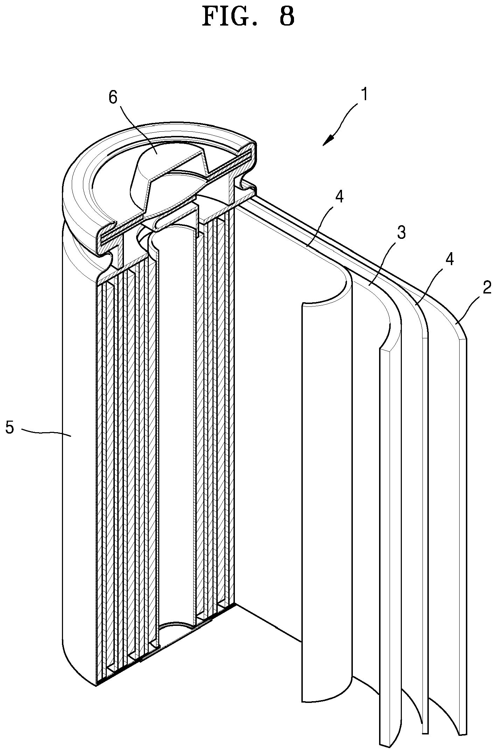

As shown in FIG. 8, a lithium battery 1 includes a positive electrode 3, a negative electrode 2, and a separator 4. In some embodiments, the positive electrode 3, the negative electrode 2, and the separator 4 may be wound or folded, and then sealed in a battery case 5. In some embodiments, the battery case 5 may be filled with an organic electrolytic solution and sealed with a cap assembly 6, thereby completing the manufacture of the lithium battery 1. In some embodiments, the battery case 5 may be a cylindrical type, a rectangular type, a pouch type, a coin type, or a thin-film type. For example, the lithium battery 1 may be a thin-film type battery. In some embodiments, the lithium battery 1 may be a lithium ion battery.

In some embodiments, the separator 4 may be disposed between the positive electrode 3 and the negative electrode 2 to form a battery assembly. In some embodiments, the battery assembly may be stacked in a bi-cell structure and impregnated with the electrolytic solution, and the resultant assembly may be put into a pouch and hermetically sealed, thereby completing the manufacture of a lithium ion polymer battery.

In some embodiments, a plurality of battery assemblies may be stacked to form a battery pack, which may be used in any device that requires high capacity and high output, for example, in a laptop computer, a smart phone, or an electric vehicle.

The lithium battery may have improved lifespan characteristics and high-rate characteristics, and thus may be used in an electric vehicle (EV), for example, in a hybrid vehicle such as a plug-in hybrid electric vehicle (PHEV). Also, the lithium battery may be applicable to the high-power storage field. For example, the lithium battery may be used in an electric bicycle, a power tool, or a system for storing electric power.

One or more embodiments will now be described in more detail with reference to the following examples. However, these examples are not intended to limit the scope of the one or more embodiments.

### (Preparation of positive electrode active material)

### Example 1

100 g of Ni_{0.8}Co_{0.1}Mn_{0.1}(OH)₂, 41.8 g of Li₂CO₃, 3.0 g ofWO₃,0.27 g of MgCO₃, 0.24 g of TiO₂, 0.45 g of NaOH, and 0.75 g of (NH₄)2S were mechanically mixed for about 15 minutes to prepare a powder mixture. The powder mixture was heat-treated at 1,000 °C for 4 hours and at 700 °C for 10 hours to obtain a lithium transition metal oxide particle.

Subsequently, 100 g of the lithium transition metal oxide particle was added to a solution prepared by dissolving 2 g of cobalt acetate in ethanol, and the resultant was stirred for 30 minutes and remained at 80 °C to remove ethanol, and thus obtained powder was fired at 800 °C for 3 hours to obtain a positive electrode active material. The specific composition of the obtained positive electrode active material is shown in Table 1.

### Example 2

100 g of Ni_{0.90}Co_{0.05}Al_{0.05}(OH)₂, 42.4 g of Li₂CO₃, 3.0 g of WO₃, 0.27 g of MgCO₃, 0.24 g of TiO₂, 0.45 g of NaOH, and 0.75 g of (NH₄)₂S were mechanically mixed for about 15 minutes to prepare a powder mixture. The powder mixture was heat-treated at 970 °C for 4 hours and at 700 °C for 10 hours to obtain a lithium transition metal oxide particle.

Subsequently, 100 g of the lithium transition metal oxide particle was added to a solution prepared by dissolving 2 g of cobalt acetate in ethanol, and the resultant was stirred for 30 minutes and remained at 80 °C to remove ethanol, and thus obtained powder was fired at 800 °C for 3 hours to obtain a positive electrode active material. The specific composition of the obtained positive electrode active material is shown in Table 1.

### Example 3

100 g of Ni_{0.9}Co_{0.1}(OH)₂, 42.0 g of Li₂CO₃, 3.0 g of WO₃, 0.27 g of MgCO₃, 0.24 g of TiO₂, 0.45 g of NaOH, and 0.75 g of (NH₄)2S were mechanically mixed for about 15 minutes to prepare a powder mixture. The powder mixture was heat-treated at 970 °C for 4 hours and at 700 °C for 10 hours to obtain a lithium transition metal oxide particle.

Subsequently, 100 g of the lithium transition metal oxide particle was added to a solution prepared by dissolving 2 g of cobalt acetate in ethanol, and the resultant was stirred for 30 minutes and remained at 80 °C to remove ethanol, and thus obtained powder was fired at 800 °C for 3 hours to obtain a positive electrode active material. The specific composition of the obtained positive electrode active material is shown in Table 1.

### Comparative Example 1

100 g of Ni_{0.8}Co_{0.1}Mn_{0.1}(OH)₂, 41.8 g of Li₂CO₃, 3.0 g ofWO₃, 0.27 g of MgCO₃, 0.24 g of TiO₂, 0.45 g of NaOH, and 0.75 g of (NH₄)2S were mechanically mixed for about 15 minutes to prepare a powder mixture. The powder mixture was heat-treated at 1,000 °C for 4 hours and at 700 °C for 10 hours to obtain a positive electrode active material. The specific composition of the obtained positive electrode active material is shown in Table 1.

### Comparative Example 2

100 g of Ni_{0.8}Co_{0.1}Mn_{0.1}(OH)₂, 41.8 g of Li₂CO₃, 0.27 g of MgCO₃, and 0.24 g of TiO₂ were mechanically mixed for about 15 minutes to prepare a powder mixture. The powder mixture was heat-treated at 1,000 °C for 4 hours and at 700 °C for 10 hours to obtain a positive electrode active material. The specific composition of the obtained positive electrode active material is shown in Table 1.

### Comparative Example 3

100 g of Ni_{0.8}Co_{0.1}Mn_{0.1}(OH)₂, 41.8 g of Li₂CO₃, 0.27 g of MgCO₃, and 0.45 g of NaOH were mechanically mixed for about 15 minutes to prepare a powder mixture. The powder mixture was heat-treated at 1,000 °C for 4 hours and at 700 °C for 10 hours to obtain a positive electrode active material. The specific composition of the obtained positive electrode active material is shown in Table 1.

### Comparative Example 4

100 g of Ni_{0.8}Co_{0.1}Mn_{0.1}(OH)₂, 41.8 g of Li₂CO₃, and 0.75 g of (NH₄)2S were mechanically mixed for about 15 minutes to prepare a powder mixture. The powder mixture was heat-treated at 1,000 °C for 4 hours and at 700 °C for 10 hours to obtain a positive electrode active material. The specific composition of the obtained positive electrode active material is shown in Table 1.

### Comparative Example 5

100 g of Ni_{0.8}Co_{0.1}Mn_{0.1}(OH)₂, 41.8 g of Li₂CO₃, 3.0 g of WO₃, and 0.27 g of MgCO₃ were mechanically mixed for about 15 minutes to prepare a powder mixture. The powder mixture was heat-treated at 1,000 °C for 4 hours and at 700 °C for 10 hours to obtain a lithium transition metal oxide particle.

Subsequently, 100 g of the lithium transition metal oxide particle was added to a solution prepared by dissolving 2 g of cobalt acetate in ethanol, and the resultant was stirred for 30 minutes and remained at 80 °C to remove ethanol, and thus obtained powder was fired at 800 °C for 3 hours to obtain a positive electrode active material. The specific composition of the obtained positive electrode active material is shown in Table 1.

### Comparative Example 6

100 g of Ni_{0.9}Co_{0.05}Al_{0.05}(OH)₂, 42.4 g of Li₂CO₃, 3.0 g of WO₃, 0.27 g of MgCO₃, 0.24 g of TiO₂, 0.45 g of NaOH, and 0.75 g of (NH₄)2S were mechanically mixed for about 15 minutes to prepare a powder mixture. The powder mixture was heat-treated at 970 °C for 4 hours and at 700 °C for 10 hours to obtain a positive electrode active material. The specific composition of the obtained positive electrode active material is shown in Table 1.

### Comparative Example 7

100 g of Ni_{0.9}Co_{0.1}(OH)₂, 42.0 g of Li₂CO₃, 3.0 g of WO₃, 0.27 g of MgCO₃, 0.24 g of TiO₂, 0.45 g of NaOH, and 0.75 g of (NH₄)2S were mechanically mixed for about 15 minutes to prepare a powder mixture. The powder mixture was heat-treated at 970 °C for 4 hours and at 700 °C for 10 hours to obtain a lithium transition metal oxide particle. The specific composition of the obtained positive electrode active material is shown in Table 1.

### (Preparation of half-cell)

### Example 4

The positive electrode active material prepared in Example 1, a conducting agent, and a binder were mixed at a weight ratio of 94:3:3 to prepare a slurry. Here, carbon black was used as the conducting agent, polyvinylidene fluoride (PVdF) was dissolved in an N-methyl-2-pyrrolidone solvent and used as the binder.

The slurry was evenly coated on an Al current collector and dried at 110 °C for 2 hours to prepare a positive electrode. A loading level of the positive electrode was about 11.0 mg/cm², and an electrode density of the positive electrode was 3.6 g/cc.

The positive electrode was used as a working electrode, lithium foil was used as a counter electrode, LiPF₆ was added to a concentration of 1.3 M in a solvent mixture prepared by mixing ethylene carbonate (EC), ethylmethyl carbonate (EMC), and diethyl carbonate (DEC) at a volume ratio of 3:4:3 to prepare a liquid electrolyte, and thus CR2032 half-cells were prepared according to a commonly known process using the working electrode, the counter electrode, and the liquid electrolyte.

### Examples 5 and 6

Half-cells were prepared in the same manner as in Example 4, except that the positive electrode active materials prepared in Examples 2 and 3 were respectively used instead of the positive electrode active material prepared in Example 1.

### Comparative Examples 8 to 14

Half-cells were prepared in the same manner as in Example 4, except that the positive electrode active materials prepared in Comparative Examples 1 to 7 were respectively used instead of the positive electrode active material prepared in Example 1.

**[Table 1]**

| Positive electrode active material/half-cell | Composition of positive electrode active material | Cobalt concentration gradient region |
|---|---|---|
| Example 1 /Example 4 | Li_{0.99}Na_{0.01}W_{0.01}Mg_{0.003}Ti_{0.003}Ni_{0.781}Co_{0.119}Mn_{0.084}O_{1.99 9}S_{0.001} | ο |
| Example 2/Example 5 | Li_{0.99}Na_{0.01}W_{0.01}Mg_{0.003}Ti_{0.003}Ni_{0.876}Co_{0.061}Al_{0.047}O_{1.999} S_{0.001} | o |
| Example 3/Example 6 | Li_{0.99}Na_{0.01}W_{0.01}Mg_{0.003}Ti_{0.003}Ni_{0.87}Co_{0.114}O_{1.999}S_{0.001} | ο |
| Comparative Example 1/Comparative Example 8 | Li_{0.99}Na_{0.01}W_{0.01}Mg_{0.003}Ti_{0.003}Ni_{0.791}Co_{0.103}Mn_{0.09}O_{1.999} S_{0.001} | X |
| Comparative Example 2/Comparative Example 9 | LiMg_{0.003}Ti_{0.003}Ni_{0.797}Co_{0.098}Mn_{0.099}O₂ | X |
| Comparative Example 3/Comparative Example 10 | Li_{0.99}Na_{0.01}Mg_{0.003}Ni_{0.798}Co_{0.099}Mn_{0.1}O₂ | X |
| Comparative Example 4/Comparative Example 11 | LiNi_{0.8}Co_{0.1}Mn_{0.1}O_{1.999}S_{0.001} | X |
| Comparative Example 5/Comparative Example 12 | LiW_{0.01}Mg_{0.003}Ni_{0.790}CO_{0.098}Mn_{0.099}O₂ | o |
| Comparative Example 6/Comparative Example 13 | Li_{0.99}Na_{0.01}W_{0.01}Mg_{0.003}Ti_{0.003}Ni_{0.879}Co_{0.047}Al_{0.049}O_{1.999} S_{0.001} | X |
| Comparative Example 7/Comparative Example 14 | Li_{0.99}Na_{0.01}W_{0.01}Mg_{0.003}Ti_{0.003}Ni_{0.886}Co_{0.098}O_{1.999}S_{0.001} | X |

### Evaluation Example 1: Evaluation of composition of positive electrode active material

Inductively coupled plasma (ICP) analysis was performed on the positive electrode active materials synthesized in Example 1 and Comparative Example 1 using 700-ES (available from Varian), and the results are shown in Table 2.

Referring to Table 2, it may be known that as the result of the ICP analysis of Comparative Example 1 and Example 1, introduction of a Co concentration gradient region on a surface of a single particle-type Ni-based positive electrode active material increases about 1 mol% of a Co element ratio in the positive electrode active material by substitution with other transition metal in the positive electrode active material, and the mole number of the other transition metal decreases. In addition, during the ICP analysis, the stoichiometric value of oxygen included in a material may be difficult to be analyzed due to inflow of a trace amount of oxygen and carbon dioxide in the atmosphere even when the analysis is performed in vacuum.

**[Table 2]**

| (mol%) | Li | Na | Ni | Co | Mn | W | Mg | Ti | S |
|---|---|---|---|---|---|---|---|---|---|
| Comparative Example 1 | 99 | 1 | 79.1 | 10.3 | 9.0 | 1 | 0.3 | 0.3 | 0.1 |
| Example 1 | 99 | 1 | 78.5 | 11.1 | 8.8 | 1 | 0.3 | 0.3 | 0.1 |

### Evaluation Example 2: Evaluation of positive electrode active material particle diameter

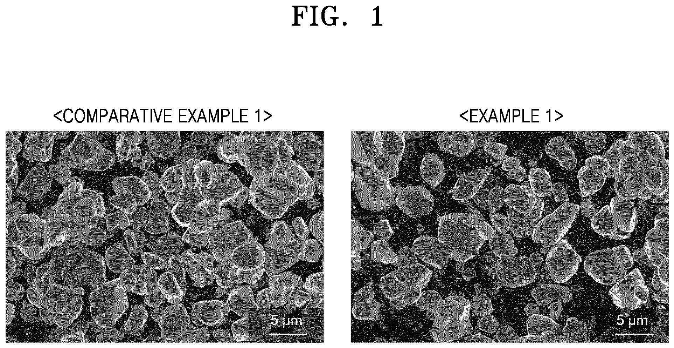

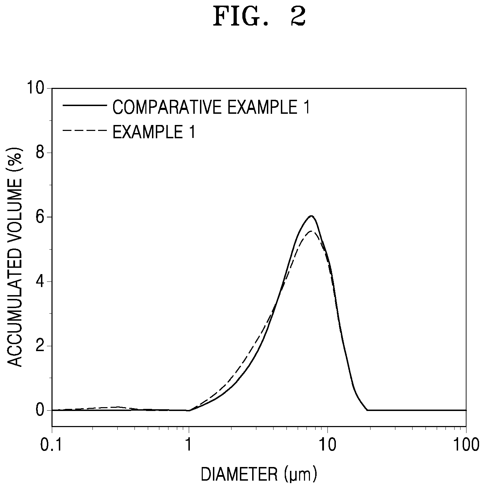

A scanning electron microscope (SEM) image of the appearance of the positive electrode active material synthesized in Example 1 and Comparative Example 1 was obtained using Verios 460 (available from FEI) and is shown in FIG. 1. Also, particle distribution of the positive electrode active material was measured using Cilas 1090 (available from Scinco) and is shown in Table 3 and FIG. 2.

Referring to Table 3 and FIGS. 1 and 2, the single-particle-type positive electrode active material of Example 1 has a Co concentration gradient region introduced thereto, but significant change in the particle diameter was not observed as compared to that of the single-particle-type positive electrode active material of Comparative Example 1, and this indicates that the Co-containing compound penetrated into the lithium transition metal oxide particle and formed a concentration gradient region.

**[Table 3]**

| | D10 (µm) | D₅₀ (µm) | D₉₀ (µm) |
|---|---|---|---|
| Comparative Example 1 | 3.0 | 5.9 | 10.1 |
| Example 1 | 2.9 | 5.8 | 9.9 |

### Evaluation Example 3: Evaluation of concentration gradient region and coating layer of positive electrode active material

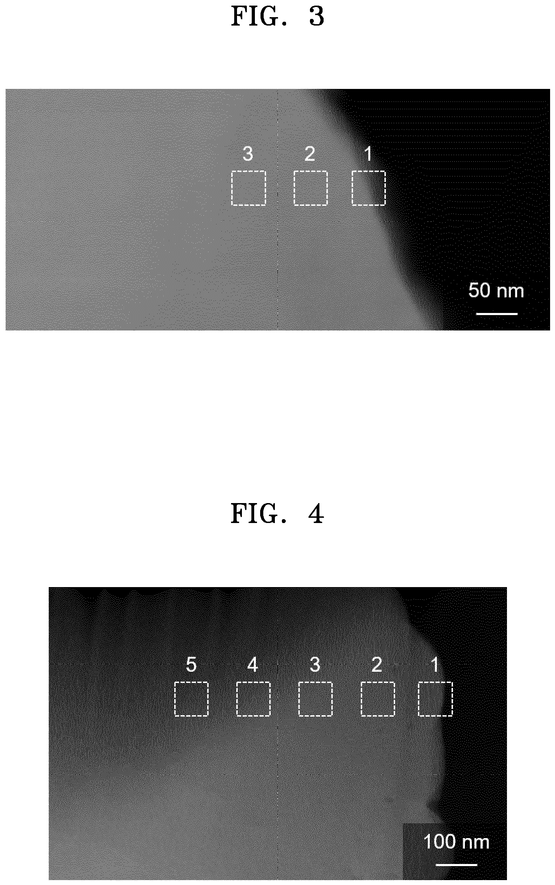

Images of the positive electrode active materials prepared in Example 1 and Comparative Example 1 were taken using a high resolution transmission electron microscopy (HR-TEM), and energy dispersive X-ray spectroscopy (EDX) analysis was performed thereon. The results are shown in Tables 4 and 5 and FIGS. 3 and 4.

**[Table 4]**

| Location | Ni (mol%) | Co (mol%) | Mn (mol%) |
|---|---|---|---|
| 1 | 79.1 | 9.9 | 10.0 |
| 2 | 79.5 | 10.8 | 9.7 |
| 3 | 79.7 | 10.3 | 9.8 |

**[Table 5]**

| Location | Ni (mol%) | Co (mol%) | Mn (mol%) |
|---|---|---|---|
| 1 | 52.8 | 27.4 | 9.8 |
| 2 | 59.9 | 20.4 | 9.7 |
| 3 | 67.8 | 22.3 | 9.9 |
| 4 | 77.9 | 12.0 | 10.1 |
| 5 | 79.8 | 10.4 | 9.8 |

Referring to Table 4 and FIG. 3, it may be known that concentrations of the transition metals in the positive electrode active material, e.g., Ni, Co, and Mn, were substantially maintained in a direction from the surface toward the center of the positive electrode active material.

Referring to Table 5 and FIG. 4, among the transition metals in the positive electrode active material, tendencies of the concentration of Co decreasing in a direction from the surface toward the center of the positive electrode active material and the concentration of Ni increasing in the opposite direction were confirmed. Also, it may be known that a thickness of the Co concentration gradient layer was about 500 nm. Without being bound by any particular theory, since cobalt ions among the transition metals contribute to structural stability of the positive electrode active material having a layered structure, as compared to nickel ions, the structural stability of the positive electrode active material during charging and discharging is improved by including a large amount of cobalt, which is relatively stable, in the surface of the positive electrode active material, and thus it is deemed that the long lifespan characteristics are improved.

### Evaluation Example 4: Room-temperature lifespan evaluation

After resting the half-cells prepared in Examples 4 to 6 and Comparative Examples 8 to 14 for 10 hours, the half-cells were charged at 0.1 C until 4.3 V with a constant current (CC) mode, and then the half-cells were charged until a current corresponding to 0.05 C with a constant voltage (CV) mode. Next, the half-cells were discharged at 0.1 C until 3.0 V with a CC mode to complete a formation process.

Subsequently, the half-cells were charged at 0.1 C until 3.0 V with a CC mode at room-temperature (25 °C) at 0.5 C until 4.3 V with a CC mode, and then the half-cells were charged until a current corresponding to 0.05 C with a CV mode. Next, the half-cells were discharged at 1 C until 3.0 V with a CC mode, and this charging/discharging process was repeated 50 times.

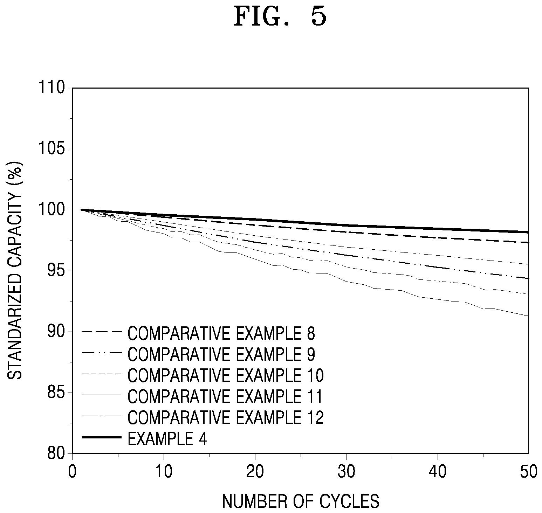

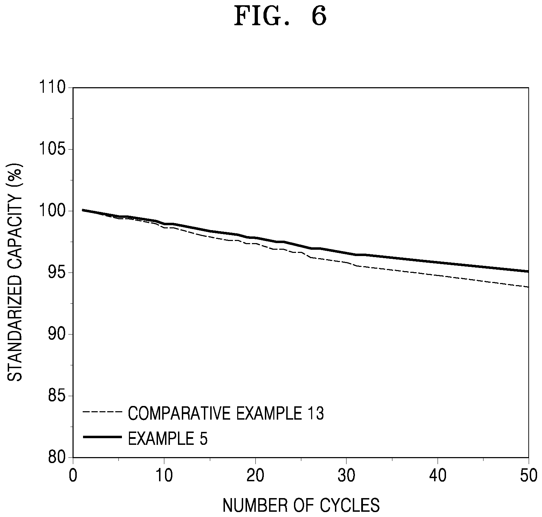

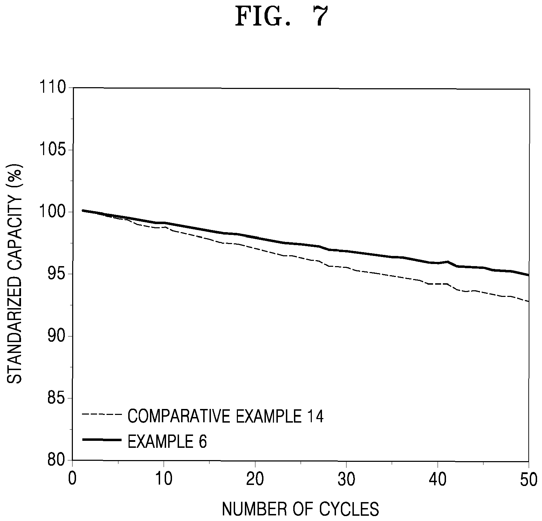

Capacity retention rates of the half-cells after 50 times of charging/discharging cycles with respect to the initial capacity were calculated, and the results are shown in Table 7. Also, graphs representing the capacity retention rates according to cycles are shown in FIGS. 5 to 7.

**[Table 6]**

| Positive electrode active material/half-cell | Composition of positive electrode active material | Cobalt concentration gradient region | Lifespan retention rate after 50 cycles (%) |
|---|---|---|---|
| Example 1 /Example 4 | Li_{0.99}Na_{0.01}W_{0.01}Mg_{0.003}Ti_{0.003}Ni_{0.781}Co_{0.119}Mn_{0.08 4}O_{1.999}S_{0.001} | ο | 98.1 |
| Example 2/Example 5 | Li_{0.99}Na_{0.01}W_{0.01}Mg_{0.003}Ti_{0.003}Ni_{0.876}Co_{0.061}Al_{0.047} O_{1.999}S_{0.001} | ο | 94.8 |
| Example 3/Example 6 | Li_{0.99}Na_{0.01}W_{0.01}Mg_{0.003}Ti_{0.003}Ni_{0.87}Co_{0.114}O_{1.999}S _{0.001} | ο | 95.0 |
| Comparative Example 1/Comparative Example 8 | Li_{0.99}Na_{0.01}W_{0.01}Mg_{0.003}Ti_{0.003}Ni_{0.791}Co_{0.103}Mn_{0.09} O_{1.999}S_{0.001} | X | 95.3 |
| Comparative Example 2/Comparative Example 9 | LiMg_{0.003}Ti_{0.003}Ni_{0.797}Co_{0.098}Mn_{0.099}O₂ | X | 94.4 |
| Comparative Example 3/Comparative Example 10 | Li_{0.99}Na_{0.01}Mg_{0.003}Ni_{0.798}Co_{0.099}Mn_{0.1}O₂ | X | 93.1 |
| Comparative Example 4/Comparative Example 11 | LiNi_{0.8}Co_{0.1}Mn_{0.1}O_{1.999}S_{0.001} | X | 91.3 |
| Comparative Example 5/Comparative Example 12 | LiW_{0.01}Mg_{0.003}Ni_{0.790}CO_{0.098}Mn_{0.099}O₂ | o | 95.6 |
| Comparative Example 6/Comparative Example 13 | Li_{0.99}Na_{0.01}W_{0.01}Mg_{0.003}Ti_{0.003}Ni_{0.879}Co_{0.047}Al_{0.049} O_{1.999}S_{0.001} | X | 93.2 |
| Comparative Example 7/Comparative Example 14 | Li_{0.99}Na_{0.01}W_{0.01}Mg_{0.003}Ti_{0.003}Ni_{0.886}Co_{0.098}O_{1.999} S_{0.001} | X | 92.7 |

Referring to Table 6 and FIG. 5, according to the results of the room-temperature lifespan test of Example 4 and Comparative Example 8, the case including a concentration gradient region (Example 4) showed about 3 % improved lifespan retention rate in the 50th cycle, as compared to that of the case not including a concentration gradient region. This is deemed due to suppressing deterioration of the positive electrode active material as cobalt contributing structural stability of the layered structure of a relatively large amount is distributed on the surface of the positive electrode active material. Moreover, the half-cell of Example 4 showed up to about 7 % improved lifespan retention rate at the 50th cycle, as compared to those of Comparative Examples 9 to 11 to which the positive electrode active materials not including a concentration gradient region and at least one element selected from Na, W, Mg, Ti, and S is not introduced. In addition, when at least one element selected from Na, W, Mg, Ti, and S was not introduced to the half-cell, and which includes a concentration gradient region, the half-cell showed about 3 % improved lifespan retention rate as compared to that of Comparative Example 12 using, for example, a positive electrode active material in which Ti element was not introduced.

Through these data, it was confirmed that when a positive electrode active material includes Na, W, Mg, Ti, and S element and a concentration gradient region, excellent lifespan characteristics of the positive electrode active material may be obtained by a synergistic effect therebetween.

Also, it was confirmed that including the concentration gradient region improved about 2 to 3 % of the lifespan characteristics in cases of a nickel-cobalt-aluminum (NCA)-based positive electrode active material and a nickel-cobalt (NC)-based positive electrode active material, in addition to a nickel-cobalt-manganese (NCM)-based positive electrode active material.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope as defined by the following claims.

## Claims

1. A positive electrode active material, comprising a lithium transition metal oxide particle in which a portion of Li is substituted with Na, and which comprises Ni and Co atoms,
wherein the lithium transition metal oxide particle comprises a concentration gradient region in which a concentration of Co atoms decreases from a surface toward a center of the particle.

2. The positive electrode active material of claim 1, wherein the concentration gradient region has a concentration of Ni atoms increasing from the surface toward the center of the lithium transition metal oxide particle.

3. The positive electrode active material of claim 1, wherein the concentration gradient region comprises a region up to a distance of 500 nm from the surface toward the center of the lithium transition metal oxide particle.

4. The positive electrode active material of claim 1, wherein the lithium transition metal oxide particle comprises a lithium transition metal oxide represented by Formula 1:
Formula 1 Li₁₋ₓNaₓM_{1-(α+β+γ)}W_{α}Mg_{β}Ti_{γ}O₂₋ₐSₐ
wherein, in Formula 1,
M is at least one element selected from alkali metal elements, alkaline earth metal elements, transition metal elements, post-transition metal elements, and non-metal elements, other than W, Mg, Ti, Na, and S, and
0<x≤0.01, O<α≤0.01, 0<β≤0.005, 0<γ≤0.005, 0<a≤0.01, and O<α+β+γ≤0.02.

5. The positive electrode active material of claim 1, wherein in Formula 1, β and y are O<β≤0.003 and 0<γ≤0.003, respectively.

6. The positive electrode active material of claim 1, wherein M is at least one element selected from Ni, Co, Mn, Al, V, Ca, Zr, B, and P.

7. The positive electrode active material of claim 6, wherein M is Ni and at least one element selected from Co, Mn, and Al.

8. The positive electrode active material of claim 1, wherein the lithium transition metal oxide is a single particle.

9. The positive electrode active material of claim 1, wherein the lithium transition metal oxide is a single crystal.

10. The positive electrode active material of claim 1, wherein the lithium transition metal oxide is represented by one of Formulae 2 to 4:
Formula 2 Li_{1-x'}Na_{x'}Ni_{y1'}CO_{y2'}Mn_{y3'}W_{α'}Mg_{β'}Ti_{γ'}O_{2-a'}S_{a'}
Formula 3 Li_{1-xʺ}Na_{xʺ}Ni_{y1ʺ}CO_{y2"}Al_{y3"}W_{α"}Mg_{β}ʺTi_{γ"}O_{2-aʺ}S_{a"}
Formula 4 Li_{1-x‴}Na_{x‴}Ni_{y1‴}CO_{y2‴}W_{α‴}Mg_{β‴}Ti_{γ‴}O_{2-a‴}Sₐ
wherein, in Formula 2,
0<x'≤0.01, 0<α'≤0.01, 0<β'≤0.005, 0<γ'≤0.005, 0<a'≤0.01, 0<α'+β'+γ'≤0.02, 0.48≤y1 '<1, 0<y2'≤0.2, 0<y3'≤0.3, and y1 '+y2'+y3'+ α'+ β'+ γ'=1;
in Formula 3,
0<x"≤0.01, 0<α"≤0.01, 0<β"≤0.005, 0<γ"≤0.005, 0<a"≤0.01, 0<α"+β"+γ"<0.02, 0.73≤y1 "<1, 0<y2"≤0.2, 0<y3"≤0.05, and y1 "+y2"+y3"+ α"+ β"+ γ"=1; and
in Formula 4,
0<x‴≤0.01, 0<α‴≤0.01, 0<β‴≤0.005, 0<γ‴≤0.005, 0<a‴≤0.01, 0<α‴+β‴+γ‴≤0.02, 0.78≤y1 "'<1, 0<y2‴≤0.2, and y1 "'+y2"'+ α‴+ β‴+ γ‴=1.

11. The positive electrode active material of claim 10, wherein,
in Formula 2, 0<β'≤0.003, 0<γ'≤0.003, and 0<α'+β'+γ'≤0.016;
in Formula 3, 0<β"≤0.003, 0<γ"≤0.003, and 0<α"+β"+γ"≤0.016; and
in Formula 4, 0<β‴≤0.003, 0<γ‴≤0.003, and 0<α‴+β‴+γ‴≤0.016.

12. The positive electrode active material of claim 1, wherein an average particle diameter (D₅₀) is about 0.1 µm to about 20 µm.

13. A method of preparing a positive electrode active material, the method comprising:
preparing a lithium transition metal oxide particle in which a portion of Li is substituted with Na, and which comprises Ni and Co atoms;
obtaining a positive electrode active material precursor by mixing the lithium transition metal oxide particle and a Co-containing compound; and
heat-treating the positive electrode active material precursor to obtain a positive electrode active material,
wherein the positive electrode active material includes a concentration gradient region in which a concentration of Co atoms decreases from a surface of the positive electrode active material particle toward the center of the particle.

14. The method of claim 13, wherein the preparing of the lithium transition metal oxide particle comprises:
mixing a Li-containing compound, a Na-containing compound, a W-containing compound, a Mg-containing compound, a Ti-containing compound, a M-containing compound, and a S-containing compound to prepare a lithium transition metal oxide precursor; and
heat-treating the lithium transition metal oxide precursor to prepare a positive electrode active material comprising a lithium transition metal oxide represented by Formula 1:
Formula 1 Li₁₋ₓNaₓM_{1-(α+β+γ)}W_{α}Mg_{β}Ti_{γ}O₂₋ₐSₐ
wherein, in Formula 1,
M is at least one element selected from alkali metal elements, alkaline earth metal elements, transition metal elements, post-transition metal elements, and non-metal elements, other than W, Mg, Ti, Na, and S, and
0<x≤0.01, O<α≤0.01, 0<β≤0.005, 0<γ≤0.005, 0<a≤0.01, and 0<α+β+γ≤0.02.

15. The method of claim 14, wherein the mixing comprises mechanical mixing.

16. The method of claim 14, wherein the heat-treating of the precursor comprises a first heat-treating process and a second heat-treating process,
wherein a heat-treating temperature of the first heat-treating process is higher than a heat-treating temperature of the second heat-treating process.

17. The method of claim 13, wherein, in the obtaining of the positive electrode active material precursor, the Co-containing compound is comprised in an organic solvent.

18. The method of claim 13, wherein the concentration gradient region comprises a region of 500 nm or less from the surface toward the center of the lithium transition metal oxide particle.

19. The method of claim 13, wherein the heat-treating of the lithium transition metal oxide precursor is performed at a temperature in a range of about 500 °C to about 900 °C for about 1 hour to about 6 hours.

20. A positive electrode comprising:
the positive electrode active material of any one of claims 1 to 12;
a negative electrode; and
an electrolyte.
